# EUROPEAN PATENT APPLICATION

(11) **EP 4 776 287 A1**
(43) Date of publication of application: **15.07.2026**
(21) Application number: 25188307.0
(22) Date of filing: 09.07.2025
(51) Int. Cl.: G11C 11/15, H10W 42/20, H10W 70/69, H10W 72/00, H10W 72/20, H10W 76/12, H10W 76/15, H10W 90/00

(54) **MAGNETIC SHIELD STRUCTURE FOR CHIP**

(30) Priority: 13.01.2025 US 202519017904
(71) Applicant: GlobalFoundries U.S. Inc., Malta, NY 12020 (US)
(72) Inventor: Talapatra, Abhishek, 01109 Dresden (DE); Prawoto, Clarissa Cyrilla, 01109 Dresden (DE); Naik, Vinayak Bharat, 738406 Singapore (SG)
(74) Representative: Grünecker Patent- und Rechtsanwälte PartG mbB

(57) **Abstract**

Disclosed are embodiments of structure including: a chip with an embedded magnetic random access memory (eMRAM) or other on-chip component susceptible to magnetic field-induced performance degradation; and magnetic shield(s) for protecting the chip. In some embodiments, a magnetic shield includes abutting magnetic layers having different magnetic properties. In other embodiments, a magnetic shield includes abutting magnetic layers (of the same or different magnetic materials) having offset patterns of openings (e.g., through-holes or mesh). In any case, the chip can be mounted on a board and contained in a package. Such magnetic shields can be located on the package (opposite the board) and/or on the board (opposite the chip) depending upon the expected location of a potentially adverse magnetic field.

## Description

### BACKGROUND

The present disclosure relates to chips and, more particularly, to embodiments of a structure including a chip with an embedded magnetic random access memory (eMRAM) or other component susceptible to magnetic field-induced performance degradation) and a magnetic shield for protecting the chip.

Magnetic random access memory (MRAM) has become a preferred embedded non-volatile memory (NVM) option due to high speeds and stability in the automotive temperature range. Unfortunately, in environments with strong magnetic fields, magnetic immunity of such MRAMs may not be sufficient. For purposes of this disclosure, the magnetic immunity of an MRAM refers to an MRAM's ability to resist being disrupted by an external magnetic field. One technique for boosting the magnetic immunity of an MRAM is to employ magnetic shielding. However, currently available magnetic shields for chips typically target a narrow magnetic field range and may be cost prohibitive.

### SUMMARY

Disclosed herein are various embodiments of a protected chip structure. Some embodiments of the structure can include a chip and a magnetic shield adjacent to the chip. The magnetic shield can include at least a first magnetic layer and a second magnetic layer abutting the first magnetic layer and having different magnetic properties than the first magnetic layer.

Other embodiments of the structure can include a chip and a magnetic shield adjacent to the chip. The magnetic shield can include at least a first magnetic layer and a second magnetic layer abutting the first magnetic layer. The first magnetic layer and the second magnetic layer can have offset patterns of openings (e.g., through-holes).

Still other embodiments of the structure can include: a chip; and a board. The chip can be contained within a package and mounted on the board. The structure can further include a first magnetic shield abutting the package opposite the board and a second magnetic shield abutting the board opposite the chip. The first magnetic shield and the second magnetic shield can each include at least a first magnetic layer and a second magnetic layer abutting the first magnetic layer. Furthermore, within each magnetic shield, the first magnetic layer and the second magnetic layer can have different magnetic properties and/or offset patterns of openings.

It should be noted that all aspects, examples, and features of disclosed embodiments mentioned in the summary above can be combined in any technically possible way. That is, two or more aspects of any of the disclosed embodiments, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The present disclosure will be better understood from the following detailed description with reference to the drawings, which are not necessarily drawn to scale and in which:
FIGs. 1.1, 1.2, and 1.3 are cross-section diagrams illustrating embodiments of a structure 100.1, 100.2, and 100.3, respectively;
FIGs. 2.1, 2.2, and 2.3 are cross-section diagrams illustrating additional embodiments of a structure 200.1, 200.2, and 200.3, respectively;
FIG. 3 is a graph illustrating shield efficiency of individual magnetic layers compared to shield efficiency of a multi-layer magnetic shield; and
FIGs. 4A-4C are perspective drawings illustrating different examples, respectively, of offset patterns of through-holes in different magnetic layers of a magnetic shield.

### DETAILED DESCRIPTION

As mentioned above, MRAM has become a preferred embedded NVM option due to high speeds and stability in the automotive temperature range. Unfortunately, in environments with strong magnetic fields, magnetic immunity of such MRAMs may not be sufficient. For purposes of this disclosure, the magnetic immunity of an MRAM refers to an MRAM's ability to resist being disrupted by an external magnetic field. One technique for boosting the magnetic immunity of an MRAM is to employ magnetic shielding. However, currently available magnetic shields typically target a narrow magnetic field range and may be cost prohibitive.

In view of the foregoing, disclosed herein are embodiments of structure including: a chip with an eMRAM or other on-chip component susceptible to magnetic field-induced performance degradation; and magnetic shield(s) for protecting the chip. In some embodiments of the structure, a magnetic shield can be adjacent to the chip and can include at least two abutting magnetic layers having different magnetic properties. By including magnetic layers with different magnetic properties, trade-off can be made between overall shield efficiency and the range of magnetic field strengths covered by the shield. In other embodiments of the structure, a magnetic shield can be adjacent to the chip and can include at least two abutting magnetic layers having offset patterns of through-holes. By including offset patterns of through-holes in the magnetic layers, the overall amount of magnetic material for the shield can be reduced and, thus, so can cost. In these embodiments, the magnetic layers can be made of the same magnetic material or different magnetic materials (e.g., again for providing a trade-off between shield efficiency and the range of magnetic field strengths covered by the shield). In any case, the chip can be mounted on a board and contained in a package. Such magnetic shields can be located on the package (opposite the board) and/or on the board (opposite the chip) depending upon the expected location of a potentially adverse magnetic field.

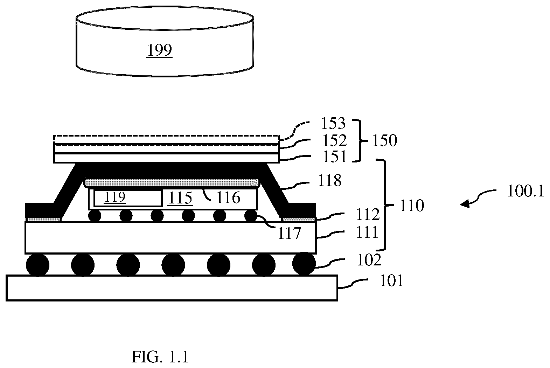

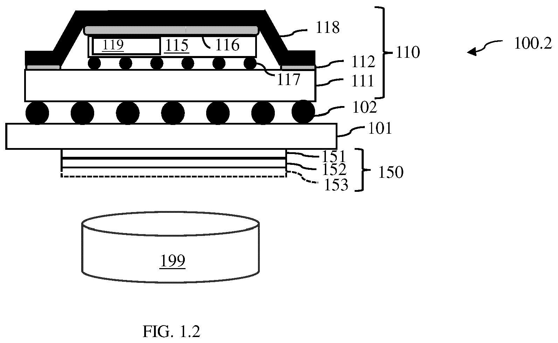

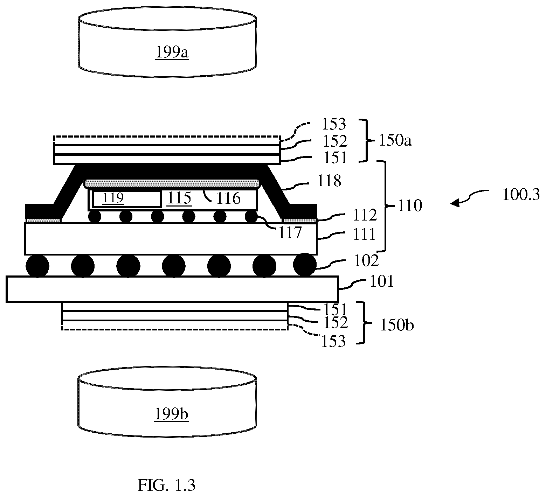

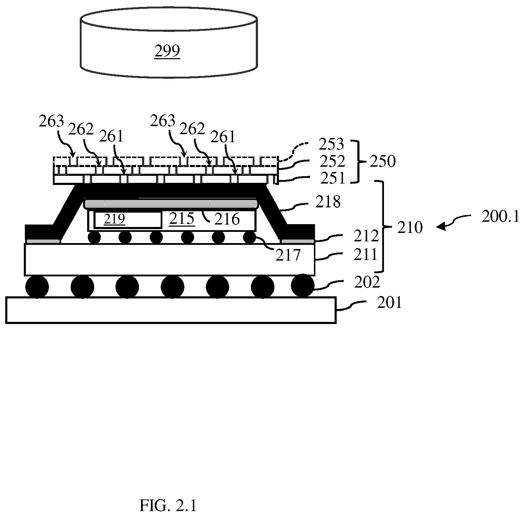

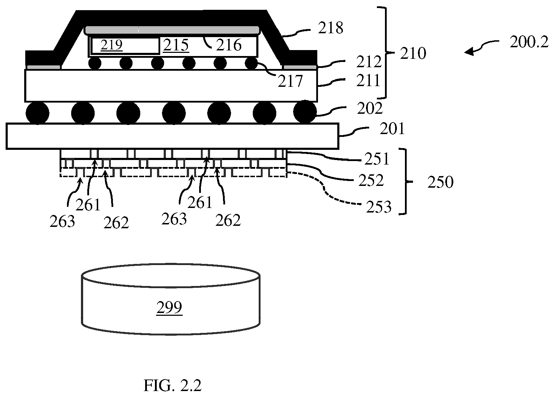

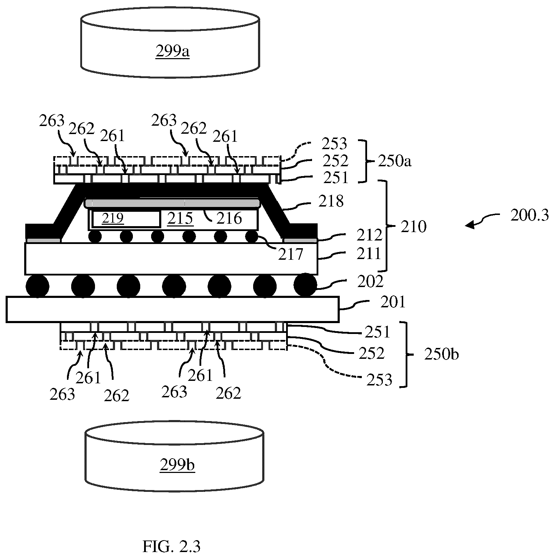

FIGs. 1.1, 1.2, and 1.3 are cross-section diagrams illustrating embodiments of a structure 100.1, 100.2, and 100.3, respectively. FIGs. 2.1, 2.2, and 2.3 are cross-section diagrams illustrating additional embodiments of a structure 200.1, 200.2, and 200.3, respectively.

In each of the embodiments, structure 100.1-100.3, 200.1-200.3 can include an integrated circuit chip 115 (herein after referred to as chip 115). Chip 115 can include at least one on-chip component 119, 219, which is susceptible to magnetic field-induced performance degradation. For example, in some embodiments, this on-chip component 119, 219 could be an embedded magnetic random access memory (eMRAM) architecture. In addition, chip 115 can include various other conventional on-chip components. The other on-chip components could include, but are not limited to, input/output(s), computer processing unit(s), sensor(s), etc.

Chip 115, 215 can be contained within a chip package 110, 210 (also referred to herein as a module). That is, chip 115, 215 could be mounted on a substrate 111, 211 (e.g., a laminate substrate) and covered by a lid 118, 218. As illustrated, chip 115, 215 could be flip-chip mounted within chip package 110, 210. That is, chip 115, 215 could be flipped relative to substrate 111, 211 such that the uppermost back end of the line (BEOL) surface is proximal to the top surface of substrate 111, 211 and chip 115, 215 can further be electrically connected to substrate 111, 211 via controlled collapse chip connections (C4 connections) 117, 217. Lid 118, 218 could be, for example, a ceramic lid, a plastic lid, or a lid of any other suitable IC packaging material. Lid 118, 218 can further have sidewalls, which laterally surround chip 115 and which are connected to the top surface of substrate 111, 211 by adhesive 112, 212. Optionally, thermal interface material 116, 216 can be sandwiched between chip 115, 215 and the underside of lid 118, 218. Alternatively, chip 115, 215 could be packaged within chip package 110, 210 using any now know or subsequently developed chip packaging technique. For example, the chip could be positioned such that the uppermost BEOL surface is distal to the top surface of a substrate. In this case, the chip could be electrically connected to substrate via wires (not shown). Additionally, a lid could cover at least the outermost surface of the chip opposite the substrate.

In any case, chip package 110, 210 and other chip package(s) and/or components (not shown) could be mounted (e.g., via solder bumps 102, 202) on a board 101, 201 (e.g., printed circuit board (PCB) or system board). Board 101, 201 can be a rigid, laminated, nonconductive structure with conductive lines printed or etched therein to form traces. Such traces in combination with solder bumps provide electrical connections between board 101, 201 and the various board-mounted components and further between different board-mounted components through board 101, 201.

In each of the embodiments, structure 100.1-100.3, 200.1-200.3 can include at least one magnetic shield 150, 250 adjacent to chip 115, 215.

In some embodiments (e.g., see structure 100.1 of FIG. 1.1 and structure 200.1 of FIG. 2.1), magnetic shield 150, 250 abuts the outer most surface of lid 118, 218 of chip package 110, 210 opposite board 101, 201. That is, in some embodiments, chip package 110, 210 is stacked between board 101, 201 and magnetic shield 150, 250. In this case, magnetic shield 150, 250 can be positioned to provide protection (i.e., shielding) against an expected magnetic field 199, 299 on the side of structure 100.1, 200.1 closest to chip 115, 215 (i.e., proximal to lid 118, 218).

In other embodiments (e.g., see structure 100.2 of FIG. 1.2 and structure 200.2 of FIG. 2.2), magnetic shield 150, 250 abuts the outer most surface of board 101, 201 opposite chip package 110, 210. That is, in these embodiments, board 101, 201 is stacked between magnetic shield 150, 250 and chip package 110, 210. In this case, magnetic shield 150, 250 can be positioned to provide protection (i.e., shielding) against an expected magnetic field 199, 299 on the side of structure 100.2, 200.2 proximal to board 101, 201.

In still other embodiments (e.g., see structure 100.3 of FIG. 1.3 and structure 200.3 of FIG. 2.3), a first magnetic shield 150a, 250a abuts the outer most surface of lid 118, 218 of chip package 110, 210 opposite board 101, 201 and a second magnetic shield 150b, 250b abuts the outer most surface of board 101, 201 opposite chip package 110, 210. That is, in these embodiments, board 101, 201 is stacked between magnetic shield 150, 250 and chip package 110, 210. In this case, first magnetic shield 150a, 250a can be positioned to provide protection (i.e., shielding) against a first expected magnetic field 199a, 299a on the side of structure 100.3, 200.3 closest to chip 115, 215 (i.e., proximal to lid 118, 218), whereas second magnetic shield 150b, 250b can be positioned to provide protection (i.e., shielding) against a second expected magnetic field 199b, 299b on the side of structure 100.3, 200.3 proximal to board 101, 201.

It should be noted that the expected magnetic field(s) can be magnetic field(s) that are internally generated within a product including structure 100.1-100.3, 200.1-200.3. For example, a product (e.g., a computerized device, smart phone, headphones, ear pods, etc.) could include a product casing and, within the product casing, chip package 110, 210 and a magnetic speaker or other magnetized device adjacent to one side or the other of chip package 110, 210 such that magnetic shields are needed.

Referring specifically to structure 100.1-100.3 of FIGs. 1.1-1.3, in some embodiments, magnetic shield 150 (or, if applicable, first and second magnetic shields 150a-150b) can include multiple abutting magnetic layers (i.e., multiple magnetic layers stack one immediately adjacent to the next) adjacent to chip 115. For example, such a magnetic shield 150 can include a first magnetic layer 151 adjacent to chip 115, a second magnetic layer 152 abutting first magnetic layer 151, and, optionally, one or more additional magnetic layers stacked thereon (e.g., see third magnetic layer 153 abutting second magnetic layer 152). In any case, the different magnetic layer (e.g., first magnetic layer 151, second magnetic layer 152, and optional third magnetic layer 153) or more can have different magnetic properties. The different magnetic properties at issue can be magnetic permeability (µᵣ) and magnetic saturation (Hsat). Those skilled in the art will recognize that magnetic permeability refers to the measure of magnetization produced in a material in response to an applied magnetic field. That is, a magnetic material with internal dipoles that become easily oriented to an applied magnetic field has high magnetic permeability and vice versa. Magnetic saturation refers to the level of magnetization above which a material can no longer continue to magnetize. That is, a magnetic material with greater magnetization capacity has a higher magnetic saturation and vice versa.

For example, first magnetic layer 151 can have a first magnetic permeability and first magnetic saturation. Second magnetic layer can have a second magnetic permeability different from the first magnetic permeability and a second magnetic saturation different from the first magnetic saturation. Third magnetic layer 153, if applicable, can have a third magnetic permeability different from the first magnetic permeability and the second magnetic permeability and can also have a third magnetic saturation different from the first magnetic saturation and the second magnetic saturation.

For example, first magnetic layer 151 can be proximal to chip 115 (i.e., closest to chip 115) with the other magnetic layer(s) stacked thereon (e.g., so that third magnetic layer 153 abuts second magnetic layer 152 opposite first magnetic layer 151 and, thus, distal to chip 115). In this case, the magnetic materials of first magnetic layer 151, second magnetic layer 152 and, if applicable, third magnetic layer 153 can be such that: (a) the first magnetic permeability, the second magnetic permeability, and the third (or even more) magnetic permeability can increase progressively (i.e., first magnetic permeability<second magnetic permeability<third magnetic permeability); and (b) the first magnetic saturation, the second magnetic saturation and the third magnetic saturation can decrease progressively (i.e., first magnetic saturation>second magnetic saturation>third magnetic saturation). Alternatively, the magnetic materials of first magnetic layer 151, second magnetic layer 152 and, if applicable, third magnetic layer 153 can be such that: (a) the first magnetic permeability, the second magnetic permeability, and the third magnetic permeability can decrease progressively (i.e., first magnetic permeability>second magnetic permeability>third magnetic permeability); and (b) the first magnetic saturation, the second magnetic saturation and the third magnetic saturation can increase progressively (i.e., first magnetic saturation<second magnetic saturation<third magnetic saturation). It should be noted that the above examples are provided for illustration purposes and are not intended to be limiting. For example, optionally, the second magnetic permeability could be either higher than both the first magnetic permeability and the third magnetic permeability or lower than both the first magnetic permeability and the second magnetic permeability.

Example magnetic materials that could be employed in magnetic shield 150 include, but are not limited to mu-metal, steel, and an iron-cobalt alloy. Mu-metal is a nickel-based alloy (e.g., a nickel-iron alloy, a nickel-iron-copper alloy, a nickel-iron-copper-chromium alloy, or a nickel-iron-copper molybdenum alloy) that can have a relatively high magnetic permeability and corresponding relatively low magnetic saturation. Iron-cobalt alloys can have a relatively low magnetic permeability and a relatively high magnetic saturation. Steel (e.g., an iron-carbon alloy) can have a mid-level magnetic permeability between that of mu-metal and iron-cobalt and a mid-level magnetic saturation between that of mu-metal and iron-cobalt. Thus, first magnetic layer 151 could be mu-metal, second magnetic layer 152 could be steel, and third magnetic layer 153, if applicable, could be iron-cobalt. Alternatively, first magnetic layer 151 could be iron-cobalt, second magnetic layer 152 could be steel, and third magnetic layer 153, if applicable, could be mu-metal. In some embodiments, the ratio of the maximum and minimum permeabilities of the different layers change over an order of magnitude.

It should be noted that in each of the embodiments described above and illustrated in FIGs. 1.1-1.3, each magnetic shield 150 is shown as including a total of three magnetic layers. However, it should be understood that the figures are not intended to be limiting. Alternatively, each magnetic shield 150 could include two or more magnetic layers. Furthermore, in the embodiment shown in FIG. 1.3 with a pair of magnetic shields 150a and 150b, the two magnetic shields could be essentially identical or the two magnetic shields could be different (e.g., different numbers of magnetic layers, different magnetic properties, and/or different thicknesses).

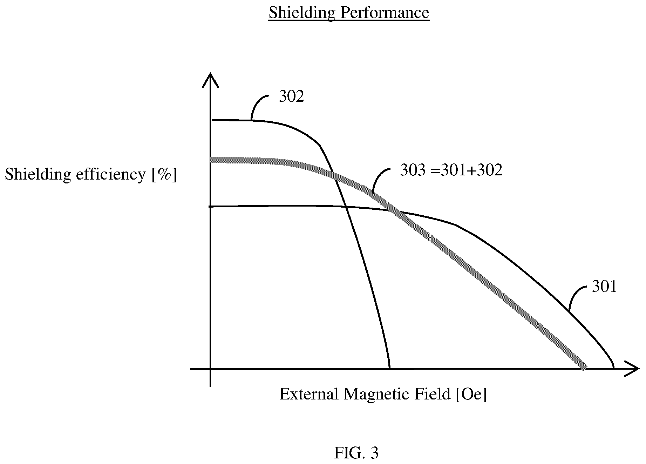

By including magnetic layers 151-152, etc. with different magnetic properties in magnetic shield(s) 150 of structure 100.1-100.3, a trade-off can be made between overall shield efficiency and the range of the magnetic field and covered by the shield. Those skilled in the art will recognize that magnetic field can be defined in units of Oersted (Oe), which is the coherent derived unit of the auxiliary magnetic field H in the centimetre-gram-second system of units (CGS). As illustrated in the graph of FIG. 3, a magnetic shield made of a single layer of magnetic material will typically either have low shield efficiency but cover a relatively wide range of magnetic field strengths (as shown in curve 301) or have a high shield efficiency but cover only a relatively narrow range of field strengths (as shown in curve 302). However, when two such magnetic layers are bonded together (e.g., as first and second magnetic layers 151-152 with different magnetic properties) to form a multi-layered magnetic shield, the multi-layered magnetic shield will have an overall shield efficiency that is between the individual shield efficiencies exhibited by the two magnetic materials, individually, and will cover a range of magnetic field strengths that is also between the ranges of magnetic field strengths covered by two magnetic materials, individually (as shown in curve 303).

Referring specifically to structure 200.1-200.3 of FIGs. 2.1-2.3, in some embodiments, magnetic shield 250 (or, if applicable, first and second magnetic shields 250a-250b) can include multiple abutting magnetic layers (i.e., multiple magnetic layers stack one immediately adjacent to the next) adjacent to chip 215. For example, such a magnetic shield 250 can include a first magnetic layer 251 adjacent to chip 215, a second magnetic layer 252 abutting first magnetic layer 251, and, optionally, one or more additional magnetic layers stacked thereon (e.g., see third magnetic layer 253 abutting second magnetic layer 252). The first magnetic layer 251, second magnetic layer 252 and, optional additional magnetic layer(s) (e.g., third magnetic layer 253) could be different magnetic materials having different magnetic properties (e.g., in essentially the same matter as described in detail above with regard to structure 100.1-100.3 of FIG. 1.1-1.3 to achieve a predetermined trade-off between overall shield efficiency and the range of magnetic field strengths covered. Alternatively, magnetic layers can be made of the same magnetic material.

In any case, the magnetic layers of magnetic shield 250 (e.g., first magnetic layer 251, second magnetic layer 252, and optional third magnetic layer 253) can have offset patterns of openings 261, 262, 263 (e.g., through-holes, or other mesh-like structures). For purposes of this disclosure, a through-hole in a magnetic layer refers to a hole, which extends vertically completely through the magnetic layer from a first surface (e.g., a bottom surface) to a second surface (e.g., a top surface) opposite the first surface. For purposes of illustration, the offset patterns of openings 261, 262, 263 in each magnetic layer are described below and illustrated in the figures as being offset patterns of through-holes. However, it should be understood that, alternatively, the offset patterns of openings could be offset patterns of opening of a mesh-like structure.

For example, first magnetic layer 251 can have a first pattern of first through-holes 261 extending vertically therethrough. Second magnetic layer 252 can have a second pattern of second through-holes 262 extending vertically therethrough. Third magnetic layer 253, if applicable, can have a third pattern of third through-holes 263 extending vertically therethrough. As mentioned above, the patterns of through-holes in the different magnetic layers are offset. That is, none of first through-holes 261 are aligned with a second through-hole 262 or a third through-hole 263, none of second through-holes 262 are aligned with a first through-hole 261 or a third through-hole 263, and so on. Furthermore, ideally, none of first through-holes 261 even partially underlay or overlay a second through-hole 262 or a third through-hole 263, none of second through-holes 262 even partially underlay or overlay a first through-hole 261 or a third through-hole 263, and so on. That is, ideally, each first through-hole 261 is completely offset from all second through-holes 262 and third through-holes 263, each second through-hole 262 is completely offset from all first through-holes 261 and third through-holes 263, and so on.

It should be noted that the shapes, sizes, number, densities of through-holes in each magnetic layer (e.g., the shapes, sizes, numbers, and densities of first through-holes 261, of second through-holes 262 and, if applicable, of third through-holes 263) can be essentially the same. In this case, the essentially the same patterns can be aligned during processing to ensure that each pattern is offset from the next. Alternatively, the shapes, sizes, numbers, and/or densities of the through-holes in each magnetic layer can be different. For example, the shapes, sizes, numbers, and/or densities of first through-holes 261, of second through-holes 262 and, if applicable, of third through-holes 263 or the through-holes of any additional magnetic layers within the magnetic shield can be different. In this case, the different patterns can be designed and aligned during processing to ensure that each pattern is offset from the next.

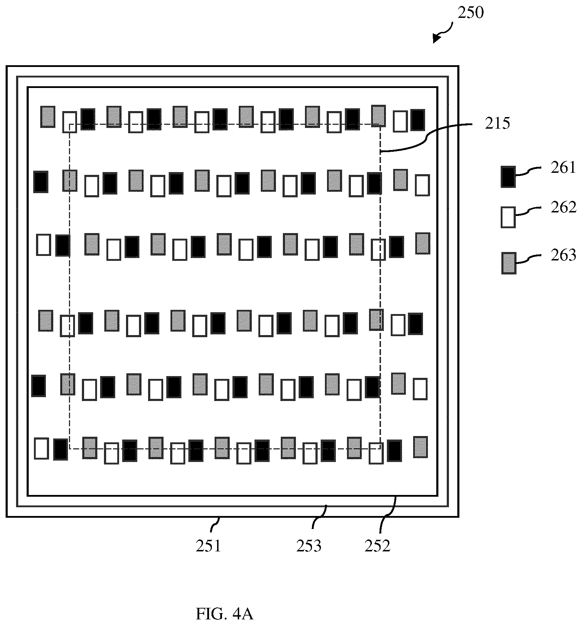

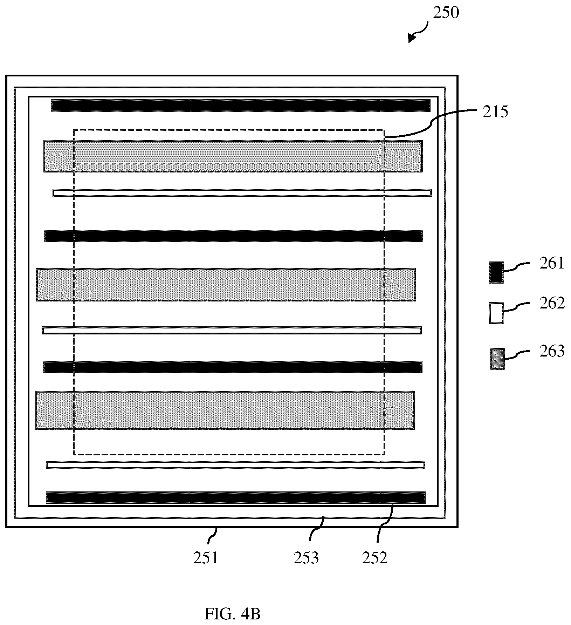

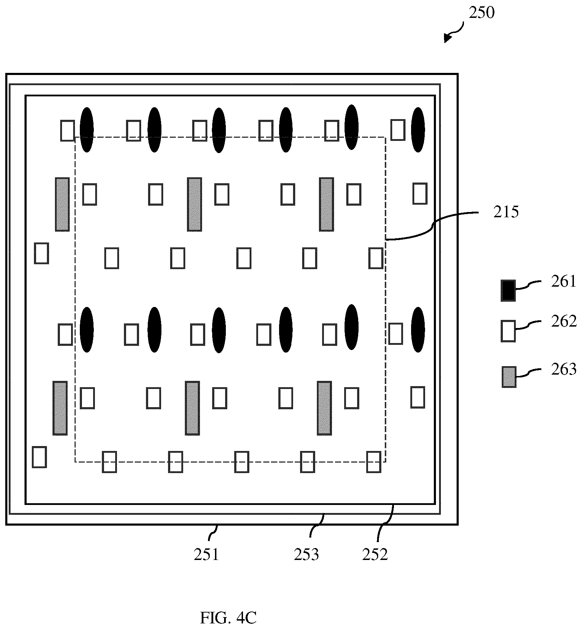

FIGs. 4A-4C are perspective drawings illustrating different examples, respectively, of offset patterns of through-holes in different magnetic layers of a magnetic shield 250. As illustrated, each drawing includes: a first pattern of first openings 261 (e.g., first through-holes, as indicated by black shapes) in first magnetic layer 251; a second pattern of second openings 262 (e.g., second through-holes, as indicated by white shapes) in second magnetic layer 252; and a third pattern of third openings 263 (e.g., third through-holes, as indicated by gray shapes) in third magnetic layer 253. In the example of FIG. 4A, the first, second, and third through-holes 261-263 in the first, second, and third magnetic layers 251-253 have similar shapes, sizes, and densities. In the example of FIG. 4B, the first, second, and third through-holes 261-263 in the first, second, and third magnetic layers 251-253 also have different sizes. In the example of FIG. 4C, the first, second, and third through-holes 261-263 in the first, second, and third magnetic layers 251-253 also have different shapes, sizes, and densities.

By including magnetic layers 251-253 with offset patterns of through-holes 261-263 in magnetic shield(s) 250 of structure 200.1-200.3, the overall amount of magnetic material required for the shield can be reduced and, thus, so can cost of producing the shield.

In the various embodiments of the structure disclosed herein (e.g., structure 100.1-100.3 of FIGs. 1.1-1.3 and structure 200.1-200.3 of FIGs. 2.1-2.3) the overall thickness of magnetic shield(s) 150, 250 can be predetermined to achieve a predetermined tradeoff between shield efficiency and size and/or cost. For example, a magnetic shield 150, 250 could be approximately 0.5 millimeters (mm) and, thus, provide an acceptable amount of shield efficiency without being overly costly.

It should be noted that in each of the embodiments described above and illustrated in FIGs. 2.1-2.3, each magnetic shield 250 is shown as including a total of three magnetic layers. However, it should be understood that the figures are not intended to be limiting. Alternatively, each magnetic shield 250 could include two or more magnetic layers. Furthermore, in the embodiment shown in FIG. 2.3 with a pair of magnetic shields 250a and 250b, the two magnetic shields could be essentially identical or the two magnetic shields could be different (e.g., different numbers of magnetic layers, different magnetic properties, different through-hole patters, and/or different thicknesses). Furthermore, although not illustrated, various additional embodiments are also anticipated. For example, in a structure having a pair of magnetic shields one of the magnetic shields could be configured essentially the same as a magnetic shield 150, as described above, and the other magnetic shield could be configured essentially the same as a magnetic shield 250, as described above.

Also disclosed herein are method embodiments for forming a structure (e.g., structure 100.1-100.3, 200.1-200.3), as described in detail above and illustrated in FIGs. 1.1-1.3 and 2.1-2.3). The method can include forming a chip 115, 215 (including at least one on-chip component 119, 219, such as an eMRAM, which is susceptible to magnetic field-induced performance degradation) and further producing a chip package 110, 210 containing chip 115, 215. Techniques for forming chips and for producing chip packages containing chips are well known in the art. Thus, the details thereof have been omitted from the specification in order to allow the reader to focus on the salient aspects of the disclosed embodiments.

Some embodiments of the method can include forming one or more magnetic shields 150, as described in detail above and illustrated in FIGs. 1.1-1.3. To form such a magnetic shield 150, plates of different magnetic materials can be selected for use in the different magnetic layers. Then, the plate for first magnetic layer 151 could be attached to the outer most surface of lid 118 or board 101 through an adhesive (e.g., an epoxy-based adhesive). The plate for second magnetic layer 152 can be bonded to outermost surface of the plate for the first magnetic layer 151 through, for example, cold roll bonding (CRB). Those skilled in the art will recognize that CRB refers to a solid-phase welding process that joins two or more sheets of metal by rolling them (e.g., at room temperature). Alternatively, any other suitable known or subsequently developed technique for bonding magnetic layers without an insulator therebetween. For example, the magnetic layers of the multi-layer magnetic shield could be formed through a deposition process (e.g., a physical vapor deposition (PVD) process). Similarly, the plate for third magnetic layer 153 can be bonded to outmost surface of the plate for the second magnetic layer 153 through CRB or any other suitable known or subsequently developed technique for bonding magnetic layers without an insulator therebetween.

Other embodiments of the method can include forming one or more magnetic shields 250, as described in detail above and illustrated in FIGs. 2.1-12.3. To form such a magnetic shield 250, plates of the same or different magnetic materials can be selected for use in the different magnetic layers. Then, each plate can be patterned with a corresponding pattern of through-holes such that the patterns of through-holes will be offset from layer to layer. Patterning of through-holes can be achieved, for example, using a masked etch process, a punch process, or any other suitable technique for patterning openings through plates. Following through-hole patterning. Then, the plate for first magnetic layer 251 and having first through-holes 261 could be attached to the outer most surface of lid 218 or board 201 through an adhesive (e.g., an epoxy-based adhesive). The plate for second magnetic layer 252 and having second through-holes 262 can be bonded to outermost surface of the plate for the first magnetic layer 251 through, for example, CRB or any other suitable known or subsequently developed technique for bonding magnetic layers without an insulator therebetween. Similarly, the plate for third magnetic layer 253 and having the third through-holes 263 can be bonded to outmost surface of the plate for the second magnetic layer 253 through CRB or any other suitable known or subsequently developed technique for bonding magnetic layers without an insulator therebetween. As mentioned above, alternatively, the magnetic layers with offset patterns of openings could be different mesh-like structures bonded together with any suitable bonding technique.

It should be understood that in the method embodiments disclosed herein the design decision to place magnetic shield 150, 250 on one or both sides of chip 115, 215 will depend upon the expected location of a potentially adverse magnetic field in or near a product that will contain structure 100.1-100.1 of FIGs. 1.1-1.3 or 200.1-200.3 of FIG. 2.1-2.3. Furthermore, the overall thickness of the magnetic shield(s), the numbers of magnetic layers in the magnetic shield(s), the different magnetic properties of the magnetic layers in magnetic shield(s), and/or the sizes, shapes, densities, numbers, etc. of the through-holes in the offset patterns of through-holes in the magnetic layers can all be predetermined so as to achieve a predetermined tradeoff between shield efficiency and size and/or cost.

It should be understood that the terminology used herein is for the purpose of describing the disclosed structures and methods and is not intended to be limiting. For example, as used herein, the singular forms "a," "an," and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

The method as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various disclosed embodiments have been presented for purposes of illustration but are not intended to be exhaustive or limiting. Many modifications and variations will be apparent to those of ordinary skill in the art without departing from the scope and spirit of the disclosed embodiments. The terminology used herein was chosen to best explain the principles of the embodiments, the practical application or technical improvement over technologies found in the marketplace, or to enable others of ordinary skill in the art to understand the embodiments disclosed herein.

In summary, embodiments of a structure are disclosed, the structure including: a chip with an embedded magnetic random access memory (eMRAM) or other on-chip component susceptible to magnetic field-induced performance degradation; and magnetic shield(s) for protecting the chip. In some embodiments, a magnetic shield includes abutting magnetic layers having different magnetic properties. In other embodiments, a magnetic shield includes abutting magnetic layers (of the same or different magnetic materials) having offset patterns of openings (e.g., through-holes or mesh). In any case, the chip can be mounted on a board and contained in a package. Such magnetic shields can be located on the package (opposite the board) and/or on the board (opposite the chip) depending upon the expected location of a potentially adverse magnetic field.
The following embodiments are explicitly disclosed.

### Embodiment 1:

A structure comprising:
a chip; and
a magnetic shield adjacent to the chip, wherein the magnetic shield includes:
   a first magnetic layer; and
   a second magnetic layer abutting the first magnetic layer and further having different magnetic properties than the first magnetic layer.

### Embodiment 2

The structure of embodiment 1,
wherein the first magnetic layer has a first magnetic permeability and first magnetic saturation, and
wherein the second magnetic layer has a second magnetic permeability different from the first magnetic permeability and a second magnetic saturation different from the first magnetic saturation.

### Embodiment 3:

The structure of embodiment 2,
wherein the magnetic shield further includes: at least one additional magnetic layer including a third magnetic layer abutting the second magnetic layer opposite the first magnetic layer, and
wherein the third magnetic layer has a third magnetic permeability different from the first magnetic permeability and the second magnetic permeability and further has a third magnetic saturation different from the first magnetic saturation and the second magnetic saturation.

### Embodiment 4:

The structure of embodiment 3,
wherein the first magnetic layer is proximal to the chip and the third magnetic layer is distal to the chip,
wherein the first magnetic permeability, the second magnetic permeability, and the third magnetic permeability any of increase and decrease progressively.

### Embodiment 5:

The structure of embodiment 3 or 4,
wherein the first magnetic layer is proximal to the chip and the third magnetic layer is distal to the chip, and
wherein the second magnetic permeability is one of higher and lower than the first magnetic permeability and the third magnetic permeability.

### Embodiment 6:

The structure of one of embodiments 1 to 5, further including: a board, wherein the chip is contained within a package and mounted on the board.

### Embodiment 7:

The structure of embodiment 6, wherein the magnetic shield abuts the package opposite the board.

### Embodiment 8:

The structure of embodiment 7, further comprising an additional magnetic shield abutting the board opposite the chip.

### Embodiment 9:

The structure of embodiment 6, wherein the magnetic shield abuts the board opposite the chip.

### Embodiment 10:

The structure of one of embodiments 1 to 9, wherein the chip includes an embedded magnetic random access memory and wherein the magnetic shield boosts magnetic immunity of the embedded magnetic random access memory from an adjacent magnetic field.

### Embodiment 11:

A structure comprising:
a chip; and
a magnetic shield adjacent to the chip, wherein the magnetic shield includes:
   a first magnetic layer; and
   a second magnetic layer abutting the first magnetic layer, wherein the first magnetic layer and the second magnetic layer have offset patterns of openings.

### Embodiment 12:

The structure of embodiment 11, wherein the first magnetic layer and the second magnetic layer have any of the same magnetic properties and different magnetic properties.

### Embodiment 13:

The structure of embodiment 11 or 12, wherein the first magnetic layer has first through-holes and the second magnetic layer has second through-holes that are completely offset from the first through-holes.

### Embodiment 14:

The structure of embodiment 13, wherein the magnetic shield further includes: a third magnetic layer abutting the second magnetic layer opposite the first magnetic layer and further having third through-holes completely offset from the first through-holes and the second through-holes.

### Embodiment 15:

The structure of embodiment 13 or 14, wherein any of shapes, sizes, and numbers of the first through-holes and the second through-holes are different.

### Embodiment 16:

The structure of one of embodiments 11 to 15, further including: a board, wherein the chip is contained within a package and mounted on the board.

### Embodiment 17:

The structure of embodiment 16, wherein the magnetic shield abuts the package opposite the board.

### Embodiment 18:

The structure of embodiment 17, further comprising an additional magnetic shield abutting the board opposite the chip.

### Embodiment 19:

The structure of embodiment 16, wherein the magnetic shield abuts the board opposite the chip.

### Embodiment 20:

A structure comprising:
a chip;
a board, wherein the chip is contained within a package and mounted on the board;
a first magnetic shield abutting the package opposite the board; and
a second magnetic shield abutting the board opposite the chip,
wherein the first magnetic shield and the second magnetic shield each include at least: a first magnetic layer; and a second magnetic layer abutting the first magnetic layer, and
wherein the first magnetic layer and the second magnetic layer have any different magnetic properties and offset patterns of openings.

### Embodiment 21:

A structure comprising:
a chip; and
a magnetic shield adjacent to the chip, wherein the magnetic shield includes:
   a first magnetic layer; and
   a second magnetic layer abutting the first magnetic layer.
Embodiment 21 may comprise one of embodiments 1 to 10 and 20.

### Embodiment 22:

The structure of embodiment 21, wherein the second magnetic layer further has different magnetic properties than the first magnetic layer.

### Embodiment 23:

The structure of embodiment 21 or 22,
wherein the first magnetic layer has a first magnetic permeability and first magnetic saturation, and
wherein the second magnetic layer has a second magnetic permeability different from the first magnetic permeability and a second magnetic saturation different from the first magnetic saturation.

### Embodiment 24:

The structure of embodiment 23,
wherein the magnetic shield further includes: at least one additional magnetic layer including a third magnetic layer abutting the second magnetic layer opposite the first magnetic layer, and
wherein the third magnetic layer has a third magnetic permeability different from the first magnetic permeability and the second magnetic permeability and further has a third magnetic saturation different from the first magnetic saturation and the second magnetic saturation.

### Embodiment 25:

The structure of embodiment 24,
wherein the first magnetic layer is proximal to the chip and the third magnetic layer is distal to the chip, and at least one of:
wherein the first magnetic permeability, the second magnetic permeability, and the third magnetic permeability any of increase and decrease progressively; and
wherein the second magnetic permeability is one of higher and lower than the first magnetic permeability and the third magnetic permeability

### Embodiment26:

The structure of one of embodiments 21 to 25, further including: a board, wherein the chip is contained within a package and mounted on the board.

### Embodiment 27:

The structure of embodiment 26, wherein the magnetic shield abuts the package opposite the board, preferably further comprising an additional magnetic shield abutting the board opposite the chip.

### Embodiment 28:

The structure of embodiment 26, wherein the magnetic shield abuts the board opposite the chip.

### Embodiment 29:

The structure of one of embodiments 21 to 28, wherein the chip includes an embedded magnetic random access memory and wherein the magnetic shield boosts magnetic immunity of the embedded magnetic random access memory from an adjacent magnetic field.

### Embodiment 30:

The structure of one of embodiments 21 to 29, wherein the first magnetic layer and the second magnetic layer have offset patterns of openings.
Embodiment 30 may comprise one of embodiments 11 to 20.

### Embodiment 31:

The structure of embodiment 21 to 30, wherein the first magnetic layer and the second magnetic layer have any of the same magnetic properties and different magnetic properties.

### Embodiment 32:

The structure of embodiment 21 to 31, wherein the first magnetic layer has first through-holes and the second magnetic layer has second through-holes that are completely offset from the first through-holes.

### Embodiment 33:

The structure of embodiment 32, wherein the magnetic shield further includes: a third magnetic layer abutting the second magnetic layer opposite the first magnetic layer and further having third through-holes completely offset from the first through-holes and the second through-holes.

### Embodiment 34:

The structure of embodiment 32 or 33, wherein any of shapes, sizes, and numbers of the first through-holes and the second through-holes are different.

### Embodiment 35:

A structure comprising:
a chip;
a board, wherein the chip is contained within a package and mounted on the board;
a first magnetic shield abutting the package opposite the board; and
a second magnetic shield abutting the board opposite the chip,
wherein the first magnetic shield and the second magnetic shield each include at least: a first magnetic layer; and a second magnetic layer abutting the first magnetic layer, and
wherein the first magnetic layer and the second magnetic layer have any different magnetic properties and offset patterns of openings.

## Claims

1. A structure comprising:
a chip; and
a magnetic shield adjacent to the chip, wherein the magnetic shield includes:
a first magnetic layer; and
a second magnetic layer abutting the first magnetic layer.

2. The structure of claim 1, wherein the second magnetic layer further has different magnetic properties than the first magnetic layer.

3. The structure of claim 1 or 2,
wherein the first magnetic layer has a first magnetic permeability and first magnetic saturation, and
wherein the second magnetic layer has a second magnetic permeability different from the first magnetic permeability and a second magnetic saturation different from the first magnetic saturation.

4. The structure of claim 3,
wherein the magnetic shield further includes: at least one additional magnetic layer including a third magnetic layer abutting the second magnetic layer opposite the first magnetic layer, and
wherein the third magnetic layer has a third magnetic permeability different from the first magnetic permeability and the second magnetic permeability and further has a third magnetic saturation different from the first magnetic saturation and the second magnetic saturation.

5. The structure of claim 4,
wherein the first magnetic layer is proximal to the chip and the third magnetic layer is distal to the chip, and at least one of:
wherein the first magnetic permeability, the second magnetic permeability, and the third magnetic permeability any of increase and decrease progressively; and
wherein the second magnetic permeability is one of higher and lower than the first magnetic permeability and the third magnetic permeability

6. The structure of one of claims 1 to 5, further including: a board, wherein the chip is contained within a package and mounted on the board.

7. The structure of claim 6, wherein the magnetic shield abuts the package opposite the board, preferably further comprising an additional magnetic shield abutting the board opposite the chip.

8. The structure of claim 6, wherein the magnetic shield abuts the board opposite the chip.

9. The structure of one of claims 1 to 8, wherein the chip includes an embedded magnetic random access memory and wherein the magnetic shield boosts magnetic immunity of the embedded magnetic random access memory from an adjacent magnetic field.

10. The structure of one of claims 1 to 9, wherein the first magnetic layer and the second magnetic layer have offset patterns of openings.

11. The structure of claim 1 to 10, wherein the first magnetic layer and the second magnetic layer have any of the same magnetic properties and different magnetic properties.

12. The structure of claim 1 to 11, wherein the first magnetic layer has first through-holes and the second magnetic layer has second through-holes that are completely offset from the first through-holes.

13. The structure of claim 12, wherein the magnetic shield further includes: a third magnetic layer abutting the second magnetic layer opposite the first magnetic layer and further having third through-holes completely offset from the first through-holes and the second through-holes.

14. The structure of claim 12 or 13, wherein any of shapes, sizes, and numbers of the first through-holes and the second through-holes are different.

15. A structure comprising:
a chip;
a board, wherein the chip is contained within a package and mounted on the board;
a first magnetic shield abutting the package opposite the board; and
a second magnetic shield abutting the board opposite the chip,
wherein the first magnetic shield and the second magnetic shield each include at least: a first magnetic layer; and a second magnetic layer abutting the first magnetic layer, and
wherein the first magnetic layer and the second magnetic layer have any different magnetic properties and offset patterns of openings.
